# EUROPÄISCHE PATENTSCHRIFT

(11) **EP 1 441 396 B1**
(45) Veröffentlichungstag und Bekanntmachung des Hinweises auf die Patenterteilung: **01.06.2011**
(21) Anmeldenummer: 04009017.7
(22) Anmeldetag: 26.06.1997
(51) Int. Cl.: H01L 33/00

(54) **Licht abstrahlendes Halbleiterbauelement mit Lumineszenzkonversionselement**
Light-emitting semiconductor device with luminescence conversion element
Dispositif semi-conducteur luminescent avec élément de conversion de la luminescence

(30) Priorität: 26.06.1996 DE 19625622; 20.09.1996 DE 19638667
(43) Veröffentlichungstag der Anmeldung: 28.07.2004
(62) Teilanmeldung aus: 97931666.8
(73) Patentinhaber: OSRAM Opto Semiconductors GmbH, 93055 Regensburg (DE)
(72) Erfinder: Schlotter, Peter, 79112 Freiburg (DE); Reeh, Ulrike, 80905 München (DE); Schmidt, Ralf, 79279 Vörstetten (DE); Schneider, Jürgen, 99117 Freiburg (DE); Höhn, Klaus, 81301 Forchheim (DE); Stath, Norbert, 93049 Regensburg (DE); Waitl, Günter, 93049 Regensburg (DE)
(74) Vertreter: Epping - Hermann - Fischer

(56) Entgegenhaltungen:
- BE-A5- 1 007 825
- DE-A1- 3 804 293
- DE-U1- 9 013 615
- JP-U- 4 063 162
- PATENT ABSTRACTS OF JAPAN Bd. 1995, Nr. 10, 30. November 1995 (1995-11-30) -& JP 07 176794 A (NICHIA CHEM IND LTD), 14. Juli 1995 (1995-07-14)
- PATENT ABSTRACTS OF JAPAN Bd. 017, Nr. 542 (E-1441), 29. September 1993 (1993-09-29) -& JP 05 152609 A (NICHIA CHEM IND LTD), 18. Juni 1993 (1993-06-18)
- PATENT ABSTRACTS OF JAPAN Bd. 002, Nr. 133 (E-069), 8. November 1978 (1978-11-08) -& JP 53 100787 A (TOSHIBA CORP), 2. September 1978 (1978-09-02)
- MÖLLMER F ET AL: "SIEMENS SMT-TOPLED FÜR DIE OBERFLÄCHEMONTAGE" SIEMENS COMPONENTS GERMANY, Bd. 29, Nr. 4, 1991, Seiten 147-149, XP002324887
- MOELLMER F ET AL: "SIEMENS SMT TOP-LED FOR SURFACE MOUNTING" SIEMENS COMPONENTS, SIEMENS VERLAG, ERLANGEN, DE, Bd. 26, Nr. 6, 1991, Seiten 193-196, XP000874796 ISSN: 0173-1726
- PATENT ABSTRACTS OF JAPAN Bd. 003, Nr. 089 (E-126), 28. Juli 1979 (1979-07-28) & JP 54 066093 A (TOSHIBA CORP), 28. Mai 1979 (1979-05-28)
- SCHREIBEN VON HERR WUSTLICH/WUSTLICH MICRO/OPTO-ELEKTRONIK GMBH AN HERR MENDEN/MENDEN BUCHSTABEN, 22. September 1995 (1995-09-22), XP002324886
- "White-LED lamp, efficient light emission, half a production cost"" ZEITUNGSARTIKEL NIKKEI SANGYO SHIMBUN, 13. September 1996 (1996-09-13), XP002324888
- PATENT ABSTRACTS OF JAPAN Bd. 1998, Nr. 05, 30. April 1998 (1998-04-30) -& JP 10 012925 A (SATO SUSUMU), 16. Januar 1998 (1998-01-16)

## Beschreibung

Die Erfindung bezieht sich auf ein lichtabstrahlendes Halbleiterbauelement nach dem Oberbegriff des Patentanspruches 1.

Ein derartiges Halbleiterbauelement ist beispielsweise aus der Offenlegungsschrift DE 38 04 293 bekannt. Darin ist eine Anordnung mit einer Elektrolumineszenz- oder Laserdiode beschrieben, bei der das gesamte von der Diode abgestrahlte Emmissionsspektrum mittels eines mit einem fluoreszierenden, lichtwandelnden organischen Farbstoff versetzten Elements aus Kunststoff zu größeren Wellenlängen hin verschoben wird. Das von der Anordnung abgestrahlte Licht weist dadurch eine andere Farbe auf als das von der Leuchtdiode ausgesandte. Abhängig von der Art des dem Kunststoff beigefügten Farbstoffes lassen sich mit ein und demselben Leuchtdiodentyp Leuchtdiodenanordnungen herstellen, die in unterschiedlichen Farben leuchten.

Aus DE-OS 2 347 289 ist eine Infrarot(IR)-Festkörperlampe bekannt, bei der an der Kante einer IR-Diode Leuchtstoff-Material angebracht ist, das die dort abgestrahlte IR-Strahlung in sichtbares Licht umwandelt. Ziel dieser Maßnahme ist es, zu Kontrollzwecken einen möglichst geringen Teil der von der Diode abgegebenen IR-Strahlung bei gleichzeitig möglichst geringer Verminderung der Intensität der abgegebenen IR-Strahlung in sichtbares Licht umzuwandeln.

Weiterhin ist aus der EP 486 052 eine lichtemittierende Diode bekannt, bei der zwischen dem Substrat und einer aktiven elektrolumineszierenden Schicht mindestens eine Halbleiter-Photolumineszenzschicht angeordnet ist, die das von der aktiven Schicht in Richtung Substrat ausgesandte Licht eines ersten Wellenlängenbereichs in Licht eines zweiten Wellenlängenbereichs umwandelt, so daß die lichtemittierende Diode insgesamt Licht verschiedener Wellenlängenbereiche aussendet.

In vielen potentiellen Anwendungsgebieten für Leuchtdioden, wie zum Beispiel bei Anzeigeelementen im Kfz-Armaturenbrett, Beleuchtung in Flugzeugen und Autos und bei vollfarbtauglichen LED-Displays, tritt verstärkt die Forderung nach Leuchtdiodenanordnungen auf, mit denen sich mischfarbiges Licht, insbesondere weißes Licht erzeugen läßt.

In JP-07 176 794-A ist eine weißes Licht aussendende planare Lichtquelle beschrieben, bei der an einer Stirnseite einer transparenten Platte zwei blaues Licht emittierende Dioden angeordnet sind, die Licht in die transparente Platte hinein aussenden. Die transparente Platte ist auf einer der beiden einander gegenüberliegenden Hauptflächen mit einer fluoreszierenden Substanz beschichtet, die Licht emittiert, wenn sie mit dem blauen Licht der Dioden angeregt wird. Das von der fluoreszierenden Substanz emittierte Licht hat eine andere Wellenlänge als das von den Dioden emittierte blaue Licht. Bei diesem bekannten Bauelement ist es besonders schwierig, die fluoreszierende Substanz in einer Art und Weise aufzubringen, daß die Lichtquelle homogenes weißes Licht abstrahlt. Darüber hinaus bereitet auch die Reproduzierbarkeit in der Massenfertigung große Probleme, weil schon geringe Schichtdickenschwankungen der fluoreszierenden Schicht, z. B. aufgrund von Unebenheiten der Oberfläche der transparenten Platte, eine Änderung des Weißtones des abgestrahlten Lichtes hervorruft.

Der vorliegenden Erfindung liegt die Aufgabe zugrunde, ein Halbleiterbauelement der eingangs genannten Art zu entwickeln, das homogenes mischfarbiges Licht abstrahlt und das eine technisch einfache Massenfertigung mit weitestgehend reproduzierbarer Bauelementcharakteristik gewährleistet.

Diese Aufgabe wird durch ein Halbleiterbauelement nach Anspruch 1 gelöst. Vorteilhafte Weiterbildungen der Erfindung sind Gegenstand der Unteransprüche 2 bis 17. Die Unteransprüche 18 bis 20 geben bevorzugte Verwendungsmöglichkeiten des erfingungsgemäßen Halbleiterbauelements an.

Erfindungsgemäß ist vorgesehen, daß der strahlungsemittierende Halbleiterkörper eine Schichtenfolge, insbesondere eine Schichtenfolge mit einer aktiven Halbleiterschicht aus GaₓIn₁₋ₓN oder GaₓAl₁₋ₓN aufweist, die im Betrieb des Halbleiterbauelements eine elektromagnetische Strahlung eines ersten Wellenlängenbereiches aus dem ultravioletten, blauen und/oder grünen Spektralbereich aussendet. Das Lumineszenzkonversionselement wandelt einen Teil der aus dem ersten Wellenlängenbereich stammenden Strahlung in Strahlung eines zweiten Wellenlängenbereiches um, derart, daß das Halbleiterbauelement Mischstrahlung, insbesondere mischfarbiges Licht, bestehend aus Strahlung des ersten Wellenlängenbereiches und Strahlung des zweiten Wellenlängenbereiches aussendet. Das heißt beispielsweise, daß das Lumineszenzkonversionselement einen Teil der vom Halbleiterkörper ausgesandten Strahlung bevorzugt nur über einen spektralen Teilbereich des ersten Wellenlängenbereichs spektral selektiv absorbiert und im längerwelligen Bereich (im zweiten Wellenlängenbereich) emittiert. Bevorzugt weist die von dem Halbleiterkörper ausgesandte Strahlung bei einer Wellenlänge λ ≤ 520 nm ein relatives Intensitätsmaximum auf und liegt der von dem Lumineszenzkonversionselement spektral selektiv absorbierte Wellenlängenbereich außerhalb dieses Intensitätsmaximums.

Ebenso kann vorteilhafterweise mit der Erfindung auch eine Anzahl (einer oder mehrere) von aus dem ersten Wellenlängenbereich stammenden ersten spektralen Teilbereichen in mehrere zweite Wellenlängenbereiche umgewandelt werden. Dadurch ist es vorteilhafterweise möglich, vielfältige Farbmischungen und Farbtemperaturen zu erzeugen.

Das erfindungsgemäße Halbleiterbauelement hat den besonderen Vorteil, daß das über Lumineszenkonversion erzeugte Wellenlängenspektrum und damit die Farbe des abgestrahlten Lichtes nicht von der Höhe der Betriebsstromstärke durch den Halbleiterkörper abhängt. Dies hat insbesondere dann große Bedeutung, wenn die Umgebungstemperatur des Halbleiterbauelementes und folglich bekanntermaßen auch die Betriebsstromstärke stark schwankt. Besonders Leuchtdioden mit einem Halbleiterkörper auf der Basis von GaN sind diesbezüglich sehr empfindlich.

Außerdem benötigt das erfindungsgemäße Halbleiterbauelement nur eine einzige Ansteuerspannung und damit auch nur eine einzige Ansteuerschaltungsanordnung, wodurch der Bauteileaufwand für die Ansteuerschaltung des Halbleiterbauelements sehr gering gehalten werden kann.

Bei einer besonders bevorzugten Ausführungsform der Erfindung ist als Lumineszenzkonversionselement über oder auf dem Halbleiterkörper eine teiltransparente, d. h. eine für die von dem Strahlung aussendenden Halbleiterkörper ausgesandte Strahlung teilweise transparente Lumineszenzkonversionsschicht vorgesehen. Um eine einheitliche Farbe des abstrahlten Lichtes sicherzustellen, ist vorteilhafterweise die Lumineszenzkonversionsschicht derart ausgebildet, daß sie durchweg eine konstante Dicke aufweist. Dies hat den besonderen Vorteil, daß die Weglänge des von dem Halbleiterkörper abgestrahlten Lichtes durch die Lumineszenzkonversionsschicht hindurch für alle Strahlungsrichtungen nahezu konstant ist. Dadurch kann erreicht werden, daß das Halbleiterbauelement in alle Richtungen Licht derselben Farbe abstrahlt. Ein weiterer besonderer Vorteil eines erfindungsgemäßen Halbleiterbauelements gemäß dieser Weiterbildung besteht darin, daß auf einfache Weise eine hohe Reproduzierbarkeit erzielt werden kann, was für eine effiziente Massenfertigung von wesentlicher Bedeutung ist. Als Lumineszenzkonversionsschicht kann beispielsweise eine mit Leuchtstoff versetzte Lack- oder Harzschicht vorgesehen sein.

Eine andere bevorzugte Ausführungsform des erfindungsgemäßen Halbleiterbauelementes weist als Lumineszenzkonversionselement eine teiltransparente Lumineszenzkonversionsumhüllung auf, die zumindest einen Teil des Halbleiterkörpers (und evtl. Teilbereiche der elektrischen Anschlüsse) umschließt und gleichzeitig als Bauteilumhüllung (Gehäuse) genutzt sein kann. Der Vorteil eines Halbleiterbauelements gemäß dieser Ausführungsform besteht im wesentlichen darin, daß zu seiner Herstellung konventionelle, für die Herstellung von herkömmlichen Leuchtdioden (z. B. Radial-Leuchdioden) eingesetzte Produktionslinien genutzt werden können. Für die Bauteilumhüllung ist anstelle des bei herkömmlichen Leuchtdioden dafür verwendeten transparenten Kunststoffes das Material der Lumineszenzkonversionsumhüllung verwendet.

Bei weiteren vorteilhaften Ausführungsformen des erfindungsgemäßen Halbleiterbauelements und der beiden oben genannten bevorzugten Ausführungsformen besteht die Lumineszenzkonversionsschicht bzw. die Lumineszenzkonversionsumhüllung aus einem transparenten Material, z. B. Kunststoff, bevorzugt Epoxidharz, das mit mindestens einem Leuchtstoff versehen ist (Beispiele für bevorzugte Kunststoffe und Leuchtstoffe finden sich weiter unten). Auf diese Weise lassen sich Lumineszenzkonversionselemente besonders kostengünstig herstellen. Die dazu notwendigen Verfahrensschritte sind nämlich ohne großen Aufwand in herkömmliche Produktionslinien für Leuchtdioden integrierbar.

Bei einer besonders bevorzugten Weiterbildung der Erfindung bzw. der o. g. Ausführungsformen ist vorgesehen, daß der oder die zweiten Wellenlängenbereiche im Wesentlichen größere Wellenlängen aufweisen als der erste Wellenlängenbereich.

Insbesondere ist vorgesehen, daß ein zweiter spektraler Teilbereich des ersten Wellenlängenbereiches und ein zweiter Wellenlängenbereich zueinander komplementär sind. Auf diese Weise kann aus einer einzigen farbigen Lichtquelle, insbesondere einer Leuchtdiode mit einem einzigen blaues Licht abstrahlenden Halbleiterkörper, mischfarbiges, insbesondere weißes Licht erzeugt werden. Um z. B. mit einem blaues Licht aussendenden Halbleiterkörper weißes Licht zu erzeugen, wird ein Teil der von dem Halbleiterkörper ausgesandten Strahlung aus dem blauen Spektralbereich in den zu Blau komplementärfarbigen gelben Spektralbereich konvertiert. Die Farbtemperatur oder Farbort des weißen Lichtes kann dabei durch geeignete Wahl des Lumineszenzkonversionselementes, insbesondere durch eine geeignete Wahl des Leuchtstoffes, dessen Partikelgröße und dessen Konzentration, variiert werden. Darüberhinaus bieten diese Anordnungen vorteilhafterweise auch die Möglichkeit, Leuchtstoffmischungen einzusetzen, wodurch sich vorteilhafterweise der gewünschte Farbton sehr genau einstellen läßt. Ebenso können Lumineszenzkonversionselemente inhomogen ausgestaltet sein, z. B. mittels einer inhomogenen Leuchtstoffverteilung. Unterschiedliche Weglängen des Lichtes durch das Lumineszenzkonversionselement können dadurch vorteilhafterweise kompensiert werden.

Bei einer weiteren bevorzugten Ausführungsform des erfindungsgemäßen Halbleiterbauelements weist das Lumineszenzkonversionselement oder ein anderer Bestandteil einer Bauteilumhüllung zur Farbanpassung einen oder mehrere Farbstoffe auf, die keine Wellenlängenkonversion bewirken. Hierzu können die für die Herstellung von herkömmlichen Leuchdioden verwendeten Farbstoffe wie z. B. Azo-, Anthrachinon- oder Perinon-Farbstoffe eingesetzt werden.

Zum Schutz des Lumineszenzkonversionselements vor einer zu hohen Strahlenbelastung ist bei einer vorteilhaften Weiterbildung bzw. bei den o. g. bevorzugten Ausführungsformen des erfindungsgemäßen Halbleiterbauelements zumindest ein Teil der Oberfläche des Halbleiterkörpers von einer ersten, z. B. aus einem Kunststoff bestehenden transparenten Hülle umgeben, auf der die Lumineszenzkonversionsschicht aufgebracht ist. Dadurch wird die Strahlungsdichte im Lumineszenzkonversionselement und somit dessen Strahlungsbelastung verringert, was sich je nach verwendeten Materialien positiv auf die Lebensdauer des Lumineszenzkonversionselementes auswirkt.

Bei einer besonders bevorzugten Ausgestaltung der Erfindung sowie der oben genannten Ausführungsformen ist ein strahlungsemittierender Halbleiterkörper verwendet, bei dem das ausgesandte Strahlungsspektrum bei einer Wellenlänge zwischen 420nm und 460 nm, insbesondere bei 430 nm (z. B. Halbleiterkörper auf der Basis von GaₓAl₁₋ₓN) oder 450 nm (z. B. Halbleiterkörper auf der Basis von GaₓIn₁₋ₓN) ein Intensitätsmaximum aufweist. Mit einem derartigen erfindungsgemäßen Halbleiterbauelement lassen sich vorteilhafterweise nahezu sämtliche Farben und Mischfarben der C.I.E.-Farbtafel erzeugen. Der strahlungsemittierende Halbleiterkörper kann hierbei, wie oben angegeben, im Wesentlichen aus elektrolumineszierendem Halbleitermaterial aber auch aus einem anderen elektrolumineszierenden Material, wie beispielsweise Polymermaterial bestehen.

Bei einer weiteren besonders bevorzugten Weiterbildung der Erfindung und deren Ausführungsformen ist die Lumineszenzkonversionsumhüllung bzw. die Lumineszenzkonversionsschicht aus einem Lack oder aus einem Kunststoff hergestellt, beispielsweise aus einem für die Umhüllung optoelektronischer Bauelemente eingesetzten Silikon-, Thermoplast- oder Duroplastmaterial (Epoxidu. Acrylatharze). Desweiteren können z. B. aus Thermoplastmaterialien gefertigte Abdeckelemente als Lumineszenzkonversionsumhüllung eingesetzt sein. Sämtliche oben genannten Materialien lassen sich auf einfache Weise mit einem oder mehreren Leuchtstoffen versetzen.

Besonders einfach läßt sich ein erfindungsgemäßes Halbleiterbauelement dann realisieren, wenn der Halbleiterkörper in einer Ausnehmung eines gegebenenfalls vorgefertigten Gehäuses angeordnet ist und die Ausnehmung mit einem die Lumineszenzkonversionsschicht aufweisenden Abdeckelement versehen ist. Ein derartiges Halbleiterbauelement läßt sich in großer Stückzahl in herkömmlichen Produktionslinien herstellen. Hierzu muß lediglich nach der Montage des Halbleiterkörpers in das Gehäuse das Abdeckelement, beispielsweise eine Lack- oder Gießharzschicht oder eine vorgefertigtes Abdeckplatte aus Thermoplastmaterial, auf das Gehäuse aufgebracht werden. Optional kann die Ausnehmung des Gehäuses mit einem transparenten Material, beispielsweise einem transparenten Kunststoff, gefüllt sein, das insbesondere die Wellenlänge des von dem Halbleiterkörper ausgesandten Lichtes nicht verändert oder aber, falls gewünscht, bereits lumineszenzkonvertierend ausgebildet sein kann.

Bei einer aufgrund besonders einfacher Realisierbarkeit besonders bevorzugten Weiterbildung des erfindungsgemäßen Halbleiterbauelements ist der Halbleiterkörper in einer Ausnehmung eines gegebenenfalls vorgefertigten eventuell bereits mit einem Leadframe versehenen Gehäuse angeordnet und ist die Ausnehmung mit einem zumindest teiltransparenten Gießharz gefüllt, dem der Leuchtstoff bereits vor dem Ausgießen der Ausnehmung zugefügt ist. Das Lumineszenzkonversionselement ist hier somit von dem mit Leuchtstoff versehenen Verguß des Halbleiterkörpers versehen.

Ein besonders bevorzugtes Material zur Herstellung des Lumineszenzkonversionselements ist Epoxidharz, dem ein oder mehrere Leuchtstoffe zugesetzt sind. Anstelle von Epoxidharz kann aber auch Polymethylmetacrylat (PMMA) verwendet sein.

PMMA läßt sich auf einfache Weise mit organischen Farbstoffmolekülen versetzen. Zur Herstellung von grün-, gelb- und rotleuchtenden erfindungsgemäßen Halbleiterbauelementen können z. B. Farbstoffmoleküle auf Perylen-Basis verwendet sein. Im UV, im Sichtbaren oder im Infraroten leuchtende Halbleiterbauelemente können auch durch Beimischung von 4f-metallorganischen Verbindungen hergestellt werden. Insbesondere können rotleuchtende erfindungsgemäße Halbleiterbauelemente z. B. durch Beimischung von auf Eu³⁺ basierenden metallorganischen Chelaten (λ ≈ 620 nm) realisiert werden. Infrarot strahlende erfindungsgemäße Halbleiterbauelemente, insbesondere mit blaues Licht aussendenden Halbleiterkörpern, können mittels Beimischung von 4f-Chelaten oder von Ti³⁺-dotiertem Saphir hergestellt werden.

Ein weißes Licht abstrahlendes erfindungsgemäßes Halbleiterbauelement läßt sich vorteilhafterweise dadurch herstellen, daß der Leuchtstoff so gewählt wird, daß eine von dem Halbleiterkörper ausgesandte blaue Strahlung in komplementäre Wellenlängenbereiche, insbesondere Blau und Gelb, oder zu additiven Farbtripeln, z. B. Blau, Grün und Rot umgewandelt wird. Hierbei wird das gelbe bzw. das grüne und rote Licht über die Leuchtstoffe erzeugt. Der Farbton (Farbort in der CIE-Farbtafel) des dadurch erzeugten weißen Lichts kann dabei durch geeignete Wahl des/der Farbstoffes/e hinsichtlich Mischung und Konzentration variiert werden.

Geeignete organische Leuchtstoffe für ein weißes Licht abstrahlendes erfindungsgemäßes Halbleiterbauelement sind Perylen-Leuchtstoffe wie z. B. BASF Lumogen F 083 für grüne Lumineszenz, BASF Lumogen F 240 für gelbe Lumineszenz und BASF Lumogen F 300 für rote Lumineszenz. Diese Farbstoffe lassen sich auf einfache Weise z. B. transparentem Epoxidharz zusetzen.

Eine bevorzugte Methode, mit einem blaues Licht abstrahlenden Halbleiterkörper ein grün leuchtendes Halbleiterbauelement herzustellen, besteht darin, für das Lumineszenzkonversionselement UO₂⁺⁺-substituiertes Borsilikatglas zu verwenden.

Bei einer weiteren bevorzugten Weiterbildung eines erfindungsgemäßen Halbleiterbauelements bzw. der oben angegebenen vorteilhaften Ausführungsformen sind dem Lumineszenzkonversionselement oder einer anderen strahlungsdurchlässigen Komponente der Bauteilumhüllung zusätzlich lichtstreuende Partikel, sogenannte Diffusoren zugesetzt. Hierdurch läßt sich vorteilhafterweise der Farbeindruck und die Abstrahlcharakteristik des Halbleiterbauelements optimieren.

Bei einer besonders vorteilhaften Ausführungsform des erfindungsgemäßen Halbleiterbauelements besteht das Lumineszenzkonversionselement zumindest teilweise aus einem transparenten Epoxidharz, das mit einem anorganischen Leuchtstoff versehen ist. Vorteilhafterweise lassen sich nämlich anorganische Leuchtstoffe auf einfache Weise in Epoxidharz einbinden.Ein besonders bevorzugter anorganischer Leuchtstoff zur Herstellung von Weiß leuchtenden erfindungsgemäßen Halbleiterbauelementen ist der Phosphor YAG:Ce (Y₃Al₅O₁₂:Ce³⁺). Dieser läßt sich auf besonders einfache Weise in herkömmlich in der LED-Technik verwendeten transparenten Epoxidharzen mischen. Weiterhin als Leuchtstoffe denkbar sind weitere mit Seltenen Erden dotierte Granate wie z. B. Y₃Ga₅O₁₂:Ce³⁺, Y(Al,Ga)₅O₁₂:Ce³⁺ und Y(Al,Ga)₅O₁₂:Tb³⁺ sowie mit Seltenen Erden dotierte Erdalkali-Sulfide wie z. B. SrS:Ce³⁺,Na, SrS:Ce³⁺,Cl, SrS:CeCl₃, CaS:Ce³⁺ und SrSe:Ce³⁺.

Zur Erzeugung von verschiedenartig mischfarbigem Licht eignen sich darüberhinaus besonders die mit Seltenen Erden dotierten Thiogallate wie z. B. CaGa₂S₄:Ce³⁺ und SrGa₂S₄:Ce³⁺. Ebenso ist hierzu die Verwendung von mit Seltenen Erden dotierten Aluminaten wie z. B. YAlO₃:Ce³⁺, YGaO₃:Ce³⁺, Y(Al,Ga)O₃:Ce³⁺ und mit Seltenen Erden dotierten Orthosilikaten M₂SiO₅:Ce³⁺ (M: Sc, Y, Sc) wie z. B. Y₂SiO₅:Ce³⁺ denkbar. Bei allen Yttriumverbindungen kann das Yttrium im Prinzip auch durch Scandium oder Lanthan ersetzt werden.

Bei einer weiteren möglichen Ausführungsform des erfindungsgemäßen Halbleiterbauelements bestehen zumindest alle lichtdurchstrahlten Komponenten der Umhüllung, d. h. auch die Lumineszenzkonversionsumhüllung bzw. -schicht aus rein anorganischen Materialien. Das Lumineszenzkonversionselement besteht somit aus einem anorganischen Leuchtstoff, der in einem temperaturstabilen, transparenten oder teiltransparenten anorganischen Material eingebettet ist. Insbesondere besteht das Lumineszenzkonversionselement aus einem anorganischen Phosphor, der in ein vorteilhafterweise niedrig schmelzendes anorganisches Glas (z. B. Silikatglas) eingebettet ist. Eine bevorzugte Herstellungsweise für eine derartige Lumineszenzkonversionsschicht ist die Sol-Gel-Technik, mit der die gesamte Lumineszenzkonversionsschicht, d. h. sowohl der anorganische Leuchtstoff als auch das Einbettmaterial in einem Arbeitsgang hergestellt werden kann.

Um die Durchmischung der von dem Halbleiterkörper ausgesandten Strahlung des ersten Wellenlängenbereiches mit der lumineszenzkonvertierten Strahlung des zweiten Wellenlängebereiches und damit die Farbhomogenität des abstrahlten Lichtes zu verbessern, ist bei einer vorteilhaften Ausgestaltung des erfindungsgemäßen Halbleiterbauelements der Lumineszenzumhüllung bzw. der Lumineszenzkonversionsschicht und/oder einer anderen Komponente der Bauteilumhüllung zusätzlich ein im Blauen lumineszierender Farbstoff zugefügt, der eine sogenannte Richtcharakteristik der von dem Halbleiterkörper abgestrahlten Strahlung abschwächt. Unter Richtcharakteristik ist zu verstehen, daß die von dem Halbleiterkörper ausgesandte Strahlung eine bevorzugte Abstrahlrichtung aufweist.

Bei einer bevorzugten Ausgestaltung des erfindungsgemäßen Halbleiterbauelements ist zum oben genannten Zweck der Durchmischung der ausgesandten Strahlung der anorganische Leuchtstoff in Pulverform verwendet, wobei sich die Leuchtstoffpartikel in dem sie umhüllenden Stoff (Matrix) nicht lösen. Außerdem weisen der anorganische Leuchtstoff und der ihn umhüllende Stoff voneinander verschiedene Brechungsindizes auf. Dies führt vorteilhafterweise dazu, daß abhängig von der Korngröße des Leuchtstoffes, ein Anteil des nicht vom Leuchtstoff absorbierten Lichtes gestreut wird. Dadurch ist die Richtcharakteristik der von dem Halbleiterkörper abgestrahlten Strahlung effizient geschwächt, so daß die nicht absorbierte Strahlung und die lumineszenzkonvertierte Strahlung homogen gemischt werden, was zu einem räumlich homogenen Farbeindruck führt.

Ein weißes Licht abstrahlendes erfindungsgemäßes Halbleiterbauelement läßt sich besonders bevorzugt dadurch realisieren, daß einem zur Herstellung der Lumineszenzkonversionsumhüllung oder - schicht verwendeten Epoxidharz der anorganische Leuchtstoff YAG:Ce (Y₃Al₅O₁₂:Ce³⁺⁾ beigemischt ist. Ein Teil einer von dem Halbleiterkörper ausgesandten blauen Strahlung wird von dem anorganischen Leuchtstoff Y₃Al₅O₁₂:Ce³⁺ in den gelben Spektralbereich und somit in einen zur Farbe Blau komplementärfarbigen Wellenlängenbereich verschoben. Der Farbton (Farbort in der CIE-Farbtafel) des weißen Lichts kann dabei durch geeignete Wahl der Farbstoffmischung und -konzentration variiert werden.

Der anorganische Leuchtstoff YAG:Ce hat unter anderem den besonderen Vorteil, daß es sich hierbei um nicht lösliche Farbpigmente (Partikelgröße im Bereich von 10 µm) mit einem Brechungsindex von ca. 1,84 handelt. Dadurch tritt neben der Wellenlängenkonversion noch ein Streueffekt auf, der zu einer guten Vermischung von blauer Diodenstrahlung und gelber Konverterstrahlung führt.

Bei einer weiteren bevorzugten Weiterbildung eines erfindungsgemäßen Halbleiterbauelements bzw. der oben angegebenen vorteilhaften Ausführungsformen sind dem Lumineszenzkonversionselement oder einer anderen strahlungsdurchlässigen Komponente der Bauteilumhüllung zusätzlich lichtstreuende Partikel, sogenannte Diffusoren zugesetzt. Hierdurch läßt sich vorteilhafterweise der Farbeindruck und die Abstrahlcharakteristik des Halbleiterbauelements weiter optimieren.

Von besonderem Vorteil ist, daß die Leuchteffizienz von weißleuchtenden erfindungsgemäßen Halbleiterbauelementen bzw. deren o. g. Ausführungsformen mit einem im wesentlichen auf der Basis von GaN hergestellten blau leuchtenden Halbleiterkörper gegenüber der Leuchteffizienz einer Glühbirne erheblich erhöht ist. Der Grund dafür besteht darin, daß zum einen die externe Quantenausbeute derartiger Halbleiterkörper bei einigen Prozent liegt und andererseits die Lumineszenzausbeute von organischen Farbstoff-Molekülen oft bei über 90% angesiedelt ist. Darüberhinaus zeichnet sich das erfindungsgemäße Halbleiterbauelement im Vergleich zur Glühbirne durch eine extrem lange Lebensdauer, größere Robustheit und eine kleinere Betriebsspannung aus.

Vorteilhaft ist weiterhin, daß die für das menschliche Auge wahrnehmbare Helligkeit des erfindungsgemäßen Halbleiterbauelements gegenüber einem ohne Lumineszenzkonversionselement ausgestatteten, aber sonst identischen Halbleiterbauelement deutlich erhöht werden kann, da die Augenempfindlichkeit zu höherer Wellenlänge hin zunimmt.

Darüberhinaus kann mit dem erfindungsgemäßen Prinzip vortteilhafterweise auch eine von dem Halbleiterkörper neben der sichtbaren Strahlung ausgesandte ultraviolette Strahlung in sichtbares Licht umgewandelt werden. Dadurch wird die Helligkeit des vom Halbleiterkörper ausgesandten Lichts deutlich erhöht.

Das hier vorgestellte Konzept der Lumineszenzkonversion mit blauem Licht eines Halbleiterkörpers läßt sich vorteilhafterweise auch auf mehrstufige Lumineszenzkonversionselemente erweitern, nach dem Schema ultraviolett → blau → grün → gelb → rot. Hierbei werden eine Mehrzahl von spektral selektiv emittierenden Lumineszenzkonversionselementen relativ zum Halbleiterkörper hintereinander angeordnet.

Ebenso können vorteilhafterweise mehrere unterschiedlich spektral selektiv emittierende Farbstoffmoleküle gemeinsam in einen transparenten Kunststoff eines Lumineszenzkonversionselements eingebettet sein. Hierdurch ist ein sehr breites Farbenspektrum erzeugbar.

Ein besonderer Vorteil von erfindungsgemäßen weißes Licht abstrahlenden Halbleiterbauelementen, bei denen als Lumineszenzkonversionsfarbstoff insbesondere YAG:Ce verwendet ist, besteht darin, daß dieser Leuchtstoff bei Anregung mit blauem Licht eine spektrale Verschiebung von ca. 100 nm zwischen Absorption und Emission bewirkt. Dies führt zu einer wesentlichen Reduktion der Reabsorption des vom Leuchtstoff emittierten Lichtes und damit zu einer höheren Lichtausbeute. Außerdem besitzt YAG:Ce vorteilhafterweise eine hohe thermische und photochemische (z. B. UV-) Stabilität (wesentlich höher als organische Leuchtstoffe), so daß auch Weiß leuchtende Dioden für Außenanwendung und/oder hohe Temperaturbereiche herstellbar sind.

YAG:Ce hat sich bislang hinsichtlich Reabsorption, Lichtausbeute, thermischer und photochemischer Stabilität und Verarbeitbarkeit als am besten geeigneter Leuchtstoff herausgestellt.

Denkbar ist jedoch auch die Verwendung von anderen Ce-dotierten Phosphoren, insbesondere Ce-dotierten Granaten.

Besonders vorteilhaft lassen sich erfindungsgemäße Halbleiterbauelemente insbesondere aufgrund ihrer geringen Leistungsaufnahme in vollfarbtauglichen LED-Displays, zur Beleuchtung von Kfz-Innenräumen oder von Flugzeugkabinen sowie zur Beleuchtung von Anzeigevorrichtungen wie Kfz-Armaturen oder Flüssigkristallanzeigen verwenden.

Weitere Merkmale, Vorteile und Zweckmäßigkeiten der Erfindung ergeben sich aus der nachfolgenden Beschreibung von 9 Ausführungsbeispielen in Verbindung mit den Figuren 1 bis 14. Es zeigen:
Figur 1 eine schematische Schnittansicht eines ersten Ausführungsbeispieles eines erfindungsgemäßen Halbleiterbauelements;
Figur 2 eine schematische Schnittansicht eines zweiten Ausführungsbeispieles eines erfindungsgemäßen Halbleiterbauelementes;
Figur 3 eine schematische Schnittansicht durch ein drittes Ausführungsbeispiel eines erfindungsgemäße Halbleiterbauelementes;
Figur 4 eine schematische Schnittansicht eines vierten Ausführungsbeispieles eines erfindungsgemäßen Halbleiterbauelements;
Figur 5 eine schematische Schnittansicht eines fünften Ausführungsbeispieles eines erfindungsgemäßen Halbleiterbauelementes;
Figur 6 eine schematische Schnittansicht eines sechsten Ausführungsbeispieles eines erfindungsgemäßen Halbleiterbauelementes;
Figur 7 eine schematische Darstellung eines Emissionsspektrums eines blaues Licht abstrahlenden Halbleiterkörpers mit einer Schichtenfolge auf der Basis von GaN;
Figur 8 eine schematische Darstellung der Emissionsspektren zweier erfindungsgemäßer Halbleiterbauelemente, die weißes Licht abstrahlen;
Figur 9 eine schematische Schnittdarstellung durch einen Halbleiterkörper, der blaues Licht aussendet;
Figur 10 eine schematische Schnittansicht eines siebten Ausführungsbeispieles eines erfindungsgemäßen Halbleiterbauelementes;
Figur 11 eine schematische Darstellung eines Emissionsspektrums eines erfindungsgemäßen Halbleiterbauelementes, das mischfarbiges rotes Licht abstrahlt;
Figur 12 eine schematische Darstellung der Emissionsspektren von weiteren erfindungsgemäßen Halbleiterbauelementen, die weißes Licht abstrahlen;
Figur 13 eine schematische Schnittansicht eines achten Ausführungsbeispieles eines erfindungsgemäßene Halbleiterbauelementes und
Figur 14 eine schematische Schnittansicht eines neunten Ausführungsbeispieles eines erfindungsgemäßen Halbleiterbauelementes.

In den verschiedenen Figuren sind gleiche bzw. gleichwirkende Teile immer mit denselben Bezugszeichen bezeichnet.

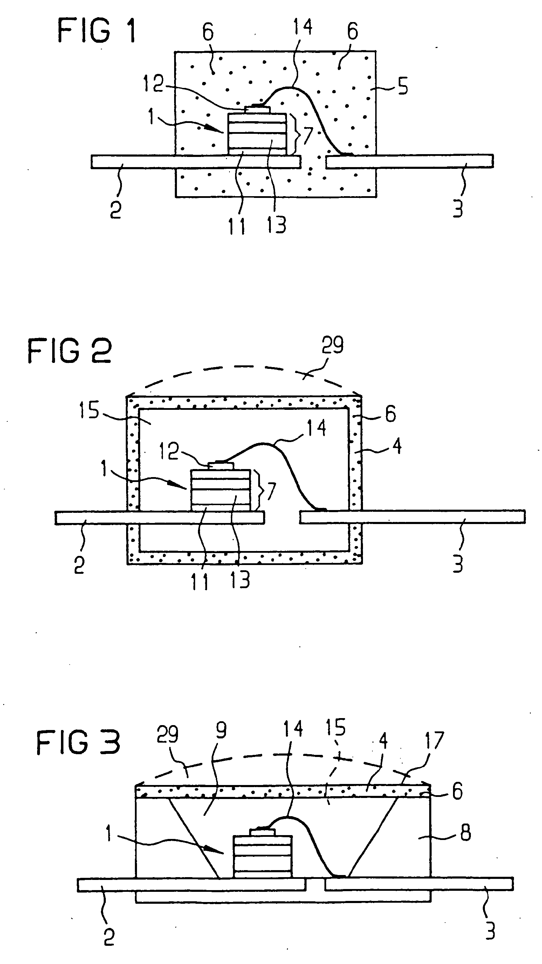

Bei dem in Figur 1 dargestellten Licht aussendenden Halbleiterbauelement weist ein Halbleiterkörper 1 einen Rückseitenkontakt 11, einen Vorderseitenkontakt 12 und eine sich aus einer Anzahl von unterschiedlichen Schichten zusammensetzende Schichtenfolge 7 auf, die im Betrieb des Halbleiterbauelements mindestens eine eine Strahlung (z. B. ultraviolett, blau oder grün) aussendende aktive Zone besitzt.

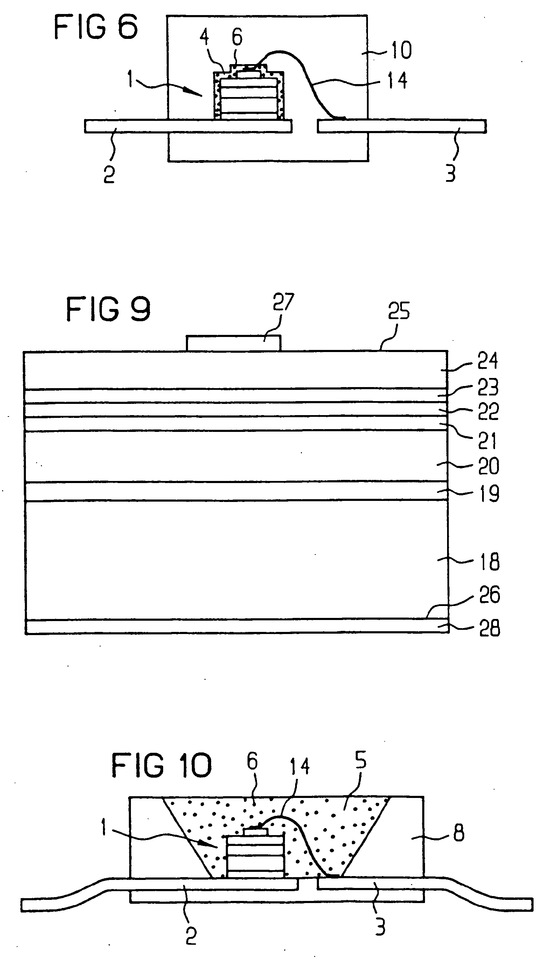

Ein Beispiel für eine geeignete Schichtenfolge 7 für dieses und für sämtliche im folgenden beschriebenen Ausführungsbeispiele ist in Figur 9 gezeigt. Hierbei ist auf einem Substrat 18, das z. B. aus SiC besteht, eine Schichtenfolge aus einer AlN- oder GaN-Schicht 19, einer n-leitenden GaN-Schicht 20, einer n-leitenden GaₓAl₁₋ₓN- oder GaₓIn₁₋ₓN-Schicht 21, einer weiteren n-leitenden GaN- oder einer GaₓIn₁₋ₓN-Schicht 22, einer p-leitenden GaₓAl₁₋ₓN- oder GaₓIn₁₋ₓN-Schicht 23 und einer p-leitenden GaN-Schicht 24 aufgebracht. Auf einer Hauptfläche 25 der p-leitenden GaN-Schicht 24 und einer Hauptfläche 26 des Substrats 18 ist jeweils eine Kontaktmetallisierung 27, 28 aufgebracht, die aus einem herkömmlich in der Opto-Halbleitertechnik für elektrische Kontakte verwendeten Werkstoff besteht.

Es kann jedoch auch jeder andere dem Fachmann für das erfindungsgemäße Halbleiterbauelement als geeignet erscheinende Halbleiterkörper verwendet werden. Dies gilt ebenso für sämtliche nachfolgend beschriebenen Ausführungsbeispiele.

Im Ausführungsbeispiel von Figur 1 ist der Halbleiterkörper 1 mittels eines elektrisch leitenden Verbindungsmittels, z. B. ein metallisches Lot oder ein Klebstoff, mit seinem Rückseitenkontakt 11 auf einem ersten elektrischen Anschluß 2 befestigt. Der Vorderseitenkontakt 12 ist mittels eines Bonddrahtes 14 mit einem zweiten elektrischen Anschluß 3 verbunden.

Die freien Oberflächen des Halbleiterkörpers 1 und Teilbereiche der elektrischen Anschlüsse 2 und 3 sind unmittelbar von einer Lumineszenzkonversionsumhüllung 5 umschlossen. Diese besteht bevorzugt aus einem für transparente Leuchtdiodenumhüllungen verwendbaren transparenten Kunststoff (bevorzugt Epoxidharz oder auch Polymethylmetaacrylat), der mit Leuchtstoff 6, bevorzugt anorganischer Leuchtstoff, für Weiß leuchtende Bauelemente bevorzugt Y₃Al₅O₁₂:Ce³⁺ (YAG:Ce), versetzt ist.

Das in Figur 2 dargestellte Ausführungsbeispiel eines erfindungsgemäßen Halbleiterbauelements unterscheidet sich von dem der Figur 1 dadurch, daß der Halbleiterkörper 1 und Teilbereiche der elektrischen Anschlüsse 2 und 3 anstatt von einer Lumineszenzkonversionsumhüllung von einer transparenten Umhüllung 15 umschlossen sind. Diese transparente Umhüllung 15 bewirkt keine Wellenlängenänderung der von dem Halbleiterkörper 1 ausgesandten Strahlung und besteht beispielsweise aus einem in der Leuchtdiodentechnik herkömmlich verwendeten Epoxid-, Silikonoder Acrylatharz oder aus einem anderen geeigneten strahlungsdurchlässigen Material wie z. B. anorganisches Glas.

Auf diese transparente Umhüllung 15 ist eine Lumineszenzkonversionsschicht 4 aufgebracht, die, wie in der Figur 2 dargestellt, die gesamte Oberfläche der Umhüllung 15 bedeckt. Ebenso denkbar ist, daß die Lumineszenzkonversionsschicht 4 nur einen Teilbereich dieser Oberfläche bedeckt. Die Lumineszenzkonversionsschicht 4 besteht beispielsweise wiederum aus einem transparenten Kunststoff (z. B. Epoxidharz, Lack oder Polymethylmetaacrylat), der mit einem Leuchtstoff 6 versetzt ist. Auch hier eignet sich als Leuchtstoff für ein weiß leuchtendes Halbleiterbauelement bevorzugt YAG:Ce.

Dieses Ausführungsbeispiel hat den besonderen Vorteil, daß für die gesamte von dem Halbleiterkörper ausgesandte Strahlung die Weglänge durch das Lumineszenzkonverionselement näherungsweise gleich groß ist. Dies spielt insbesondere dann eine bedeutende Rolle, wenn, wie oftmals der Fall, der genaue Farbton des von dem Halbleiterbauelement abgestrahlten Lichtes von dieser Weglänge abhängt.

Zur besseren Auskopplung des Lichtes aus der Lumineszenzkonversionsschicht 4 von Figur 2 kann auf einer Seitenfläche des Bauelements eine linsenförmige Abdeckung 29 (gestrichelt eingezeichnet) vorgesehen sein, die eine Totalreflexion der Strahlung innerhalb der Lumineszenzkonversionsschicht 4 reduziert. Diese linsenförmige Abdeckung 29 kann aus transparentem Kunststoff oder Glas bestehen und auf die Lumineszenzkonversionsschicht 4 beispielsweise aufgeklebt oder direkt als Bestandteil der Lumineszenzkonversionsschicht 4 ausgebildet sein.

Bei dem in Figur 3 dargestellten Ausführungsbeispiel sind der erste und zweite elektrische Anschluß 2,3 in ein lichtundurchlässiges evtl. vorgefertigtes Grundgehäuse 8 mit einer Ausnehmung 9 eingebettet. Unter "vorgefertigt" ist zu verstehen, daß das Grundgehäuse 8 bereits an den Anschlüssen 2,3 beispielsweise mittels Spritzguß fertig ausgebildet ist, bevor der Halbleiterkörper auf den Anschluß 2 montiert wird. Das Grundgehäuse 8 besteht beispielsweise aus einem lichtundurchlässigen Kunststoff und die Ausnehmung 9 ist hinsichtlich ihrer Form als Reflektor 17 für die vom Halbleiterkörper im Betrieb ausgesandte Strahlung (ggf. durch geeignete Beschichtung der Innenwände der Ausnehmung 9) ausgebildet. Solche Grundgehäuse 8 werden insbesondere bei auf Leiterplatten oberflächenmontierbaren Leuchtdioden verwendet. Sie werden vor der Montage der Halbleiterkörper auf ein die elektrischen Anschlüsse 2,3 aufweisendes Leiterband (Leadframe) z. B. mittels Spritzgießen aufgebracht.

Die Ausnehmung 9 ist von einer Lumineszenzkonversionsschicht 4, beispielsweise eine separat hergestellte und auf dem Grundgehäuse 8 befestigte Abdeckplatte 17 aus Kunststoff abgedeckt. Als geeignete Materialien für die Lumineszenzkonversionsschicht 4 kommen wiederum die weiter oben im allgemeinen Teil der Beschreibung genannten Kunststoffe oder anorganisches Glas in Verbindung mit den dort genannten Leuchtstoffen in Frage. Die Ausnehmung 9 kann sowohl mit einem transparenten Kunststoff, mit einem anorganischen Glas oder mit Gas gefüllt als auch mit einem Vakuum versehen sein.

Wie bei dem Ausführungsbeispiel nach Figur 2 kann auch hier zur besseren Auskopplung des Lichtes aus der Lumineszenzkonversionsschicht 4 auf dieser eine linsenförmige Abdeckung 29 (gestrichelt eingezeichnet) vorgesehen sein, die eine Totalreflexion der Strahlung innerhalb der Lumineszenzkonversionsschicht 4 reduziert. Diese Abdeckung 29 kann aus transparentem Kunststoff bestehen und auf die Lumineszenzkonversionsschicht 4 beispielsweise aufgeklebt oder zusammen mit der Lumineszenzkonversionsschicht 4 einstückig ausgebildet sein.

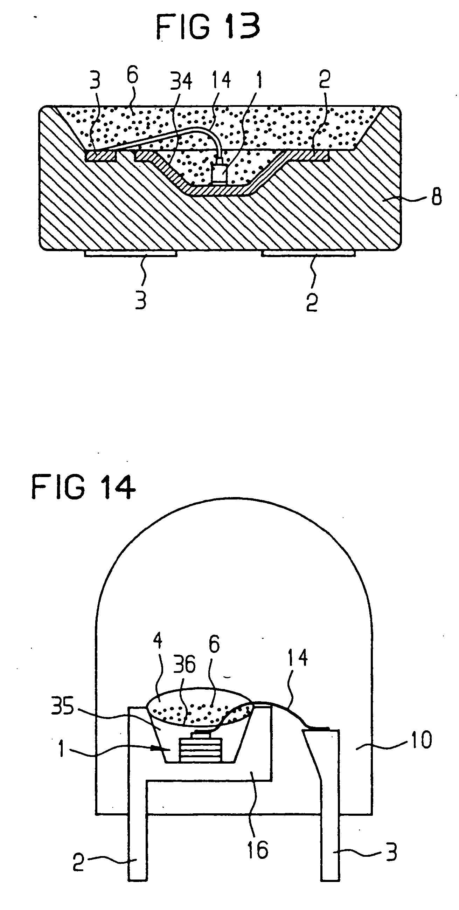

Bei einer besonders bevorzugten Ausführungsform ist die Ausnehmung 9, wie in Figur 10 gezeigt, mit einem mit Leuchtstoff versehenen Epoxidharz, d. h. mit einer Lumineszenzumhüllung 5 gefüllt, die das Lumineszenzkonversionselement bildet. Eine Abdeckplatte 17 und/oder eine linsenförmige Abdeckung 29 kann dann auch weggelassen sein. Weiterhin ist optional, wie in Figur 13 dargestellt, der erste elektrische Anschluß 2 z. B. durch Prägen im Bereich des Halbleiterkörpers 1 als Reflektorwanne 34 ausgebildet, die mit einer Lumineszenzkonversionsumhüllung 5 gefüllt ist.

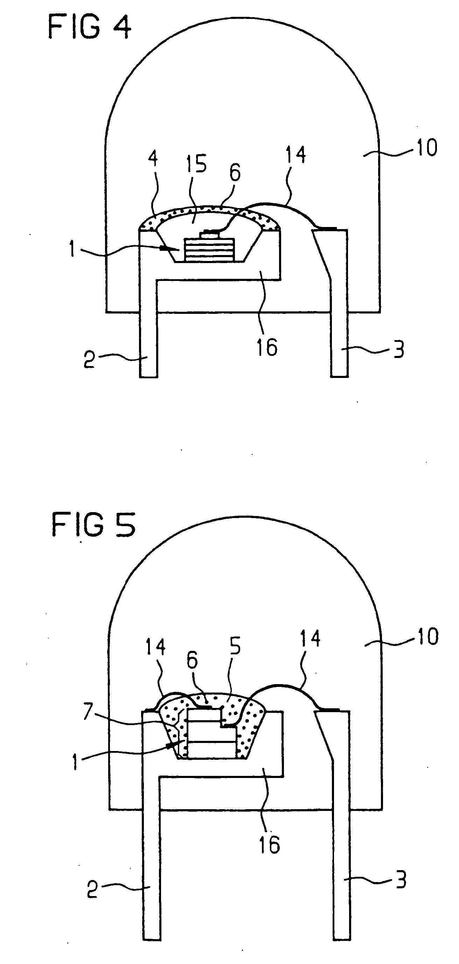

In Figur 4 ist als weiteres Ausführungsbeispiel eine sogenannte Radialdiode dargestellt. Hierbei ist der Halbleiterkörper 1 in einem als Reflektor ausgebildeten Teil 16 des ersten elektrischen Anschlußes 2 beispielsweise mittels Löten oder Kleben befestigt. Derartige Gehäusebauformen sind in der Leuchtdiodentechnik bekannt und bedürfen von daher keiner näheren Erläuterung.

Bei dem Ausführungsbeispiel von Figur 4 ist der Halbleiterkörper 1 von einer transparenten Umhüllung 15 umgeben, die, wie beim zweitgenannten Ausführungsbeispiel (Figur 2), keine Wellenlängenänderung der von dem Halbleiterkörper 1 ausgesandten Strahlung bewirkt und beispielsweise aus einem herkömmlich in der Leuchtdiodentechnik verwendeten transparenten Epoxidharz oder aus organischem Glas bestehen kann.

Auf dieser transparenten Umhüllung 15 ist eine Lumineszenzkonversionsschicht 4 aufgebracht. Als Material hierfür kommen beispielsweise wiederum die im Zusammenhang mit den vorgenannten Ausführungsbeispielen angeführten Kunststoffe oder anorganisches Glas in Verbindung mit den dort genannten Farbstoffen in Frage.

Der gesamte Aufbau, bestehend aus Halbleiterkörper 1, Teilbereiche der elektrischen Anschlüsse 2,3, transparente Umhüllung 15 und Lumineszenzkonversionsschicht 4, ist unmittelbar von einer weiteren transparenten Umhüllung 10 umschlossen, die keine Wellenlängenänderung der durch die Lumineszenzkonversionsschicht 4 hindurchgetretenen Strahlung bewirkt. Sie besteht beispielsweise wiederum aus einem herkömmlich in der Leuchtdiodentechnik verwendeten transparenten Epoxidharz oder aus anorganischem Glas.

Das in Figur 5 gezeigte Ausführungsbeispiel unterscheidet sich von dem von Figur 4 im wesentlichen dadurch, daß die freien Oberflächen des Halbleiterkörpers 1 unmittelbar von einer Lumineszenzkonversionsumhüllung 5 bedeckt sind, die wiederum von einer weiteren transparenten Umhüllung 10 umgeben ist. In Figur 5 ist weiterhin beispielhaft ein Halbleiterkörper 1 dargestellt, bei dem anstelle des Unterseitenkontaktes ein weiterer Kontakt auf der Halbleiterschichtenfolge 7 angebracht ist, der mittels eines zweiten Bonddrahtes 14 mit dem zugehörigen elektrischen Anschluß 2 oder 3 verbunden ist. Selbstverständlich sind derartige Halbleiterkörper 1 auch bei allen anderen hierin beschriebenen Ausführungsbeispielen einsetzbar. Umgekehrt ist natürlich auch bei dem Ausführungsbeispiel von Figur 5 ein Halbleiterkörper 1 gemäß den vorgenannten Ausführungsbeispielen verwendbar.

Der Vollständikeit halber sei an dieser Stelle angemerkt, daß selbstverständlich auch bei der Bauform nach Figur 5 analog zu dem Ausführungsbeispiel nach Figur 1 eine einstückige Lumineszenzkonversionsumhüllung 5, die dann an die Stelle der Kombination aus Lumineszenzkonversionsumhüllung 5 und weiterer transparenter Umhüllung 10 tritt, verwendet sein kann.

Bei dem Ausführungsbeispiel von Figur 6 ist eine Lumineszenzkonversionsschicht 4 (mögliche Materialien wie oben angegeben) direkt auf den Halbleiterkörper 1 aufgebracht. Dieser und Teilbereiche der elektrischen Anschlüsse 2,3 sind von einer weiteren transparenten Umhüllung 10 umschlossen, die keine Wellenlängenänderung der durch die Lumineszenzkonversionsschicht 4 hindurchgetretenen Strahlung bewirkt und beispielsweise aus einem in der Leuchtdiodentechnik verwendbaren transparenten Epoxidharz oder aus Glas gefertigt ist.

Solche, mit einer Lumineszenzkonversionsschicht 4 versehenen Halbleiterkörper 1 ohne Umhüllung können natürlich vorteilhafterweise in sämtlichen aus der Leuchtdiodentechnik bekannten Gehäusebauformen (z. B. SMD-Gehäuse, Radial-Gehäuse (man vergleiche Figur 5)) verwendet sein.

Bei dem in Figur 14 dargestellten Ausführungsbeispiel eines erfindungsgemäßen Halbleiterbauelements ist auf dem Halbleiterkörper 1 ein transparentes Wannenteil 35 angeordnet, das über dem Halbleiterkörper 1 eine Wanne 36 aufweist. Das Wannenteil 35 besteht beispielsweise aus transparentem Epoxidharz oder aus anorganischem Glas und ist z. B. mittels Umspritzen der elektrischen Anschlüsse 2,3 einschließlich Halbleiterkörper 1 gefertigt. In dieser Wanne 36 ist eine Lumineszenzkonversionsschicht 4 angeordnet, die z. B. wiederum aus Epoxidharz oder anorganischem Glas gefertigt ist, in das Partikel 37, bestehend aus einem der o. g. anorganischen Leuchtstoffe, eingebunden sind. Bei dieser Bauform wird vorteilhafterweise auf sehr einfache Weise sichergestellt, daß sich der Leuchtstoff während der Herstellung des Halbleiterbauelements an nicht vorgesehenen Stellen, z. B. neben dem Halbleiterkörper, ansammelt. Das Wannenteil 35 kann selbstverständlicherweise auch separat hergestellt und anderweitig, z. B. an einem Gehäuseteil, über dem Halbleiterkörper 1 befestigt sein.

Bei sämtlichen der oben beschriebenen Ausführungsbeispiele kann zur Optimierung des Farbeindrucks des abstrahlten Lichts sowie zur Anpassung der Abstrahlcharakteristik das Lumineszenzkonversionselement (Lumineszenzkonversionsumhüllung 5 oder Lumineszenzkonversionsschicht 4), ggf. die transparente Umhüllung 15, und/oder ggf. die weitere transparente Umhüllung 10 lichtstreuende Partikel, vorteilhafterweise sogenannte Diffusoren aufweisen. Beispiele für derartige Diffusoren sind mineralische Füllstoffe, insbesondere CaF₂, TiO₂, SiO₂, CaCO₃ oder BaSO₄ oder auch organische Pigmente. Diese Materialien können auf einfache Weise den o. g. Kunststoffen zugesetzt werden.

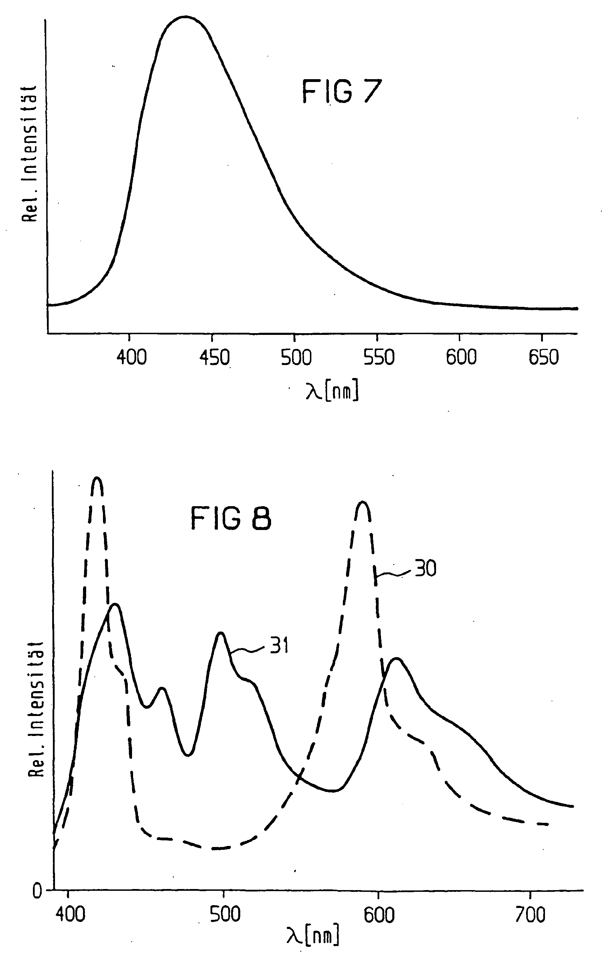

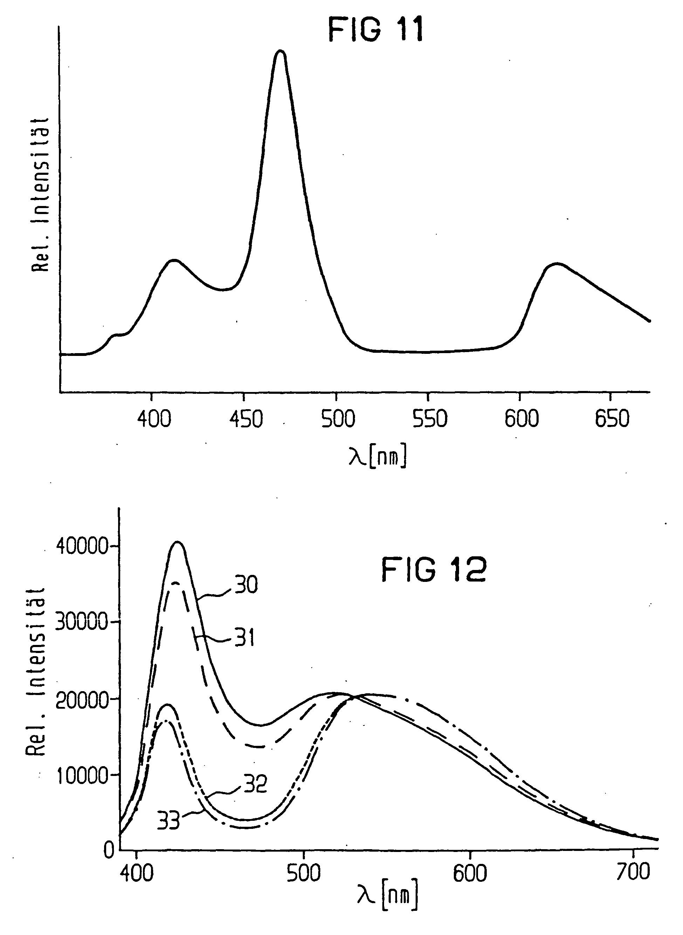

In den Figuren 7, 8 und 12 sind Emissionsspektren eines blaues Licht abstrahlenden Halbleiterkörpers (Fig. 7) (Lumineszenzmaximum bei λ ∼ 430 nm) bzw. von mittels eines solchen Halbleiterkörpers hergestellten Weiß leuchtenden erfindungsgemäßen Halbleiterbauelementen (Fig. 8 und 12) gezeigt. An der Abszisse ist jeweils die Wellenänge λ in nm und auf der Ordinate ist jeweils eine relative Elektrolumineszenz(EL)-Intensität aufgetragen.

Von der vom Halbeiterkörper ausgesandten Strahlung nach Figur 7 wird nur ein Teil in einen längerwelligen Wellenlängenbereich konvertiert, so daß als Mischfarbe weißes Licht entsteht. Die gestrichelte Linie 30 in Figur 8 stellt ein Emissionsspektrum von einem erfindungsgemäßen Halbleiterbauelement dar, das Strahlung aus zwei komplementären Wellenlängenbereichen (Blau und Gelb) und damit insgesamt weißes Licht aussendet. Das Emissionsspektrum weist hier bei Wellenlängen zwischen ca. 400 und ca. 430 nm (Blau) und zwischen ca. 550 und ca. 580 nm (Gelb) je ein Maximum auf. Die durchgezogene Linie 31 repräsentiert das Emissionsspektrum eines erfindungsgemäßen Halbleiterbauelements, das die Farbe Weiß aus drei Wellenlängenbereichen (additives Farbtripel aus Blau, Grün und Rot) mischt. Das Emissionsspektrum weist hier beispielsweise bei den Wellenlängen von ca. 430 nm (Blau), ca. 500 nm (Grün) und ca. 615 nm (Rot) je ein Maximum auf.

Desweiteren ist in Figur 11 ein Emissionsspektrum eines erfindungsgemäßen Halbleiterbauelements dargestellt, das mischfarbiges Licht aus blauem Licht (Maximum bei einer Wellenlänge von ca. 470 nm) und rotem Licht (Maximum bei einer Wellenlänge von ca. 620 nm) abstrahlt. Der Gesamtfarbeindruck des abgestrahlten Lichtes für das menschliche Auge ist Magenta. Das vom Halbleiterkörper abgestrahlte Emissionsspektrum entspricht hier wiederum dem von Figur 7.

Figur 12 zeigt ein Weiß leuchtendes erfindungsgemäßes Halbleiterbauelement, das mit einem ein Emissions-Spektrum gemeäß Figur 7 aussendenden Halbleiterkörper versehen ist und bei dem als Leuchtstoff YAG:Ce verwendet ist. Von der vom Halbeiterkörper ausgesandten Strahlung nach Figur 7 wird nur ein Teil in einen längerwelligen Wellenlängenbereich konvertiert, so daß als Mischfarbe weißes Licht entsteht. Die verschiedenartig gestrichelten Linien 30 bis 33 von Figur 8 stellen Emissionsspektren von erfindungsgemäßen Halbleiterbauelementen dar, bei denen das Lumineszenzkonversionselement, in diesem Fall eine Lumineszenzkonversionsumhüllung aus Epoxidharz, unterschiedliche YAG:Ce-Konzentrationen aufweist. Jedes Emissionsspektrum weist zwischen λ = 420 nm und λ = 430 nm, also im blauen Spektralbereich, und zwischen λ = 520 nm und λ = 545 nm, also im grünen Spektralbereich, jeweils ein Intensitätsmaximum auf, wobei die Emissionsbanden mit dem längerwelligen Intensitätsmaximum zu einem großen Teil im gelben Spektralbereich liegen. Das Diagramm von Figur 12 verdeutlicht, daß bei dem erfindungsgemäßen Halbleiterbauelement auf einfache Weise durch Veränderung der Leuchtstoffkonzentration im Epoxidharz der CIE-Farbort des weißen Lichtes verändert werden kann.

Weiterhin ist es möglich, anorganische Leuchtstoffe auf Basis von Ce-dotierten Granaten, Thiogallaten, Erdalkali-Sulfiden und Aluminaten direkt auf den Halbleiterkörper aufzubringen, ohne sie in Epoxidharz oder Glas zu dispergieren.

Ein weiterer besonderer Vorteil der oben genannten anorganischen Leuchtstoffe ergibt sich daraus, daß die Leuchtstoffkonzentration z.B. im Epoxidharz nicht wie bei organischen Farbstoffen durch die Löslichkeit begrenzt wird. Dadurch sind keine großen Dicken von Lumineszenzkonversionselementen nötig.

Die Erläuterung des erfindungsgemäßen Halbleiterbauelements anhand der oben beschriebenen Ausführungsbeispiele ist natürlich nicht als Beschränkung der Erfindung auf diese zu betrachten. Als Halbleiterkörper, wie beispielsweise Leuchtdioden-Chips oder Laserdioden-Chips, ist beispielsweise auch eine Polymer-LED zu verstehen, die ein enstprechendes Strahlungsspektrum aussendet.

## Patentansprüche

1. Leuchtdiode aufweisend
- einen Halbleiterkörper (1), der im Betrieb der Leuchtdiode elektromagnetische Strahlung aussendet, mit mindestens einem ersten und mindestens einem zweiten elektrischen Anschluss (2, 3), die mit dem Halbleiterkörper (1) elektrisch leitend verbunden sind, wobei der Halbleiterkörper (1) eine Halbleiterschichtenfolge (7) aufweist, die geeignet ist, im Betrieb des Halbleiterbauelements elektromagnetische Strahlung eines ersten Wellenlängenbereiches auszusenden, der Strahlung zumindest aus dem ultravioletten, blauen oder grünen Spektralbereich umfasst, und
- eine Lumineszenzkonversionsumhüllung (5), die zumindest einen Teil des Halbleiterkörpers (1) umschließt und die
- eine aus dem ersten Wellenlängenbereich stammende Strahlung in Strahlung eines vom ersten verschiedenen zweiten Wellenlängenbereiches umwandelt, derart, dass die Leuchtdiode Mischstrahlung bestehend aus Strahlung des ersten Wellenlängenbereiches und Strahlung des zweiten Wellenlängenbereiches aussendet, **dadurch gekennzeichnet, dass** die Lumineszenzkonversionsumhüllung (5)
- einen anorganischen Leuchtstoff (6) in Pulverform aufweist, wobei sich Leuchtstoffpartikel in einem sie umhüllenden Stoff nicht lösen und der anorganische Leuchtstoff und der ihn umhüllende Stoff voneinander verschiedene Brechungsindizes aufweisen, und
- zusätzlich zu dem anorganischen Leuchtstoff lichtstreuende Partikel aufweist.

2. Leuchtdiode nach Anspruch 1,
**dadurch gekennzeichnet, dass** das Lumineszenzkonversionselement Strahlung des ersten Wellenlängenbereichs in Strahlung mehrerer zweiter Wellenlängenbereiche aus voneinander verschiedenen spektralen Teilbereichen umwandelt, derart, dass das Halbleiterbauelement Mischstrahlung, bestehend aus Strahlung des ersten Wellenlängenbereiches und Strahlung der zweiten Wellenlängenbereiche aussendet.

3. Leuchtdiode nach einem der Ansprüche 1 bis 2,
**dadurch gekennzeichnet, dass** der bzw. die zweiten Wellenlängenbereiche größere Wellenlängen λ aufweisen, als der erste Wellenlängenbereich.

4. Leuchtdiode nach einem der Ansprüche 1 bis 3,
**dadurch gekennzeichnet, dass** der erste Wellenlängenbereich und der zweite Wellenlängenbereich der Mischstrahlung zumindest teilweise in zueinander komplementärfarbigen Spektralbereichen liegen, so dass weißes Licht erzeugt wird.

5. Leuchtdiode nach Anspruch 2 oder nach Anspruch 2 in Verbindung mit einem der Ansprüche 3 bis 4,
**dadurch gekennzeichnet, dass** der vom Halbleiterkörper ausgesandte erste Wellenlängenbereich und zwei zweite Wellenlängenbereiche ein additives Farbtripel ergeben, derart, dass in Betrieb des Halbleiterbauelements von diesem weißes Licht abgestrahlt wird.

6. Leuchtdiode nach einem der Ansprüche 1 bis 5,
**dadurch gekennzeichnet, dass** die vom Halbleiterkörper (1) ausgesandte Strahlung bei einer Wellenlänge λ ≤ 520nm, insbesondere im blauen Spektralbereich bei einer Wellenlänge zwischen 420nm und 460 nm ein Lumineszenz-Intentsitätsmaximum aufweist.

7. Leuchtdiode nach einem der Ansprüche 1 bis 6,
**dadurch gekennzeichnet, dass** der Halbleiterkörper (1) in einer Ausnehmung (9) eines Grundgehäuses (8) angeordnet ist und dass die Ausnehmung (9) zumindest teilweise von der Lumineszenzkonversionumhüllung ausgefüllt ist.

8. Leuchtdiode nach einem der Ansprüche 1 bis 7,
**dadurch gekennzeichnet, dass** die Lumineszenzkonversionsumhüllung mehrere Schichten mit unterschiedlichen Wellenlängenkonversionseigenschaften aufweist.

9. Leuchtdiode nach einem der Ansprüche 1 bis 8,
**dadurch gekennzeichnet, dass** der anorganische Leuchtstoff aus der Gruppe umfassend die mit Seltenen Erden dotierten Granate, mit Seltenen Erden dotierte Erdalkali-Sulfide, mit Seltenen Erden dotierten Thiogallate, mit Seltenen Erden dotierten Aluminate, und mit Seltenen Erden dotierten Orthosilikate stammt.

10. Leuchtdiode nach Anspruch 9,
**dadurch gekennzeichnet, dass** der der anorganische Leuchtstoff aus der Gruppe der Ce-dotierten Granate stammt, insbesondere YAG:Ce ist.

11. Leuchtdiode nach einem der Ansprüche 1 bis 10, **dadurch gekennzeichnet, dass** der anorganische Leuchtstoff in einer Matrix aus Thermoplast- oder Duroplastmaterial, wie Epoxidharze und Acrylatharze, eingebettet ist.

12. Leuchtdiode nach einem der Ansprüche 1 bis 10,
**dadurch gekennzeichnet, dass** der anorganische Leuchtstoff in einer Matrix aus einem niedrigschmelzenden anorganischen Glas eingebettet ist.

13. Leuchtdiode nach Anspruch 9,
**dadurch gekennzeichnet, dass** der anorganische Leuchtstoff Ce-dotiert und direkt auf dem Halbleiterkörper (1) aufgebracht ist.

14. Leuchtdiode nach einem der Ansprüche 1 bis 13,
**dadurch gekennzeichnet, dass** der anorganische Leuchtstoff
- YAG:Ce ist und in Epoxidharz oder ein niedrigschmelzendes anorganisches Glas eingebettet ist und
- eine mittlere Partikelgröße von ca. 10 µm aufweist.

15. Leuchtdiode nach einem der Ansprüche 1 bis 14,
**dadurch gekennzeichnet, dass** die Lumineszenzkonversionsumhüllung mit mehreren verschiedenen Leuchtstoffen (6) versehen ist.

16. Leuchtdiode nach einem der Ansprüche 1 bis 15,
**dadurch gekennzeichnet, dass** das Lumineszenzkonversionselement
Farbstoffmoleküle mit und ohne Wellenlängenkonversionswirkung aufweist.

17. Leuchtdiode nach einem der Ansprüche 1 bis 16,
**dadurch gekennzeichnet, dass** die Lumineszenzkonversionsumhüllung und/oder eine transparente Umhüllung (10, 15) mit einem im Blauen lumineszierenden Leuchtstoff versehen ist.

18. Verwendung einer Mehrzahl von Leuchtdioden gemäß einem der Ansprüche 1 bis 17 in einer vollfarbtauglichen LED-Anzeigevorrichtung.

19. Verwendung einer Mehrzahl von gemäß einem der Ansprüche 1 bis 17 zur Innenraumbeleuchtung von Flugzeugkabinen.

20. Verwendung einer leuchtdiode gemäß einem der Ansprüche 1 bis 17 zur Beleuchtung von Anzeigevorrichtungen, insbesondere zur Beleuchtung von Flüssigkristallanzeigen.

## Claims

1. Light-emitting diode comprising
- a semiconductor body (1), which during the operation of the light-emitting diode emits electromagnetic radiation, having at least one first and at least one second electrical connection (2,3) which are connected in an electrically conductive manner to the semiconductor body (1), wherein the semiconductor body (1) comprises a semiconductor layer sequence (7) which is suitable during the operation of the semiconductor component to emit electromagnetic radiation in a first wavelength range which includes radiation at least from the ultraviolet, blue or green spectral range, and
- a luminescence conversion encapsulation (5) which encloses at least a part of the semiconductor body (1) and which converts radiation originating from the first wavelength range into radiation of a second wavelength range which is different from the first, in such a manner that the light-emitting diode emits mixed radiation consisting of radiation in the first wavelength range and radiation in the second wave length range,
**characterised in that** the luminescence conversion encapsulation (5) comprises
- an inorganic luminescent material (6) in powder form, wherein particles of luminescent material do not dissolve in a material which encases them and the inorganic luminescent material and the material encasing it have different refractory indexes to each other, and
- in addition to the inorganic luminescent material comprises light-scattering particles.

2. Light-emitting diode as claimed in claim 1,
**characterised in that** the luminescence conversion element converts radiation in the first wavelength range into radiation of a plurality of second wavelength ranges from partial spectral ranges which differ from each other, in such a manner that the semiconductor component emits mixed radiation consisting of radiation in the first wavelength range and radiation in the second wavelength ranges.

3. Light-emitting diode as claimed in any one of claims 1 to 2,
**characterised in that** the second wavelength range(s) comprise greater wavelengths λ than the first wavelength range.

4. Light-emitting diode as claimed in any one of claims 1 to 3,
**characterised in that** the first wavelength range and the second wavelength range of the mixed radiation lie at least partially in spectral ranges which complement each other colour-wise, so that white light is produced.

5. Light-emitting diode as claimed in claim 2 or as claimed in claim 2 in conjunction any one of claims 3 to 4,
**characterised in that** the first wavelength range emitted by the semiconductor body and two second wavelength ranges produce an additive colour triad in such a manner that white light is emitted during the operation of the semiconductor component by the same.

6. Light-emitting diode as claimed in any one of claims 1 to 5,
**characterised in that** the radiation emitted by the semiconductor body (1) has a luminescence intensity maximum at a wavelength λ ≤ 520nm, in particular in the blue spectral range at a wavelength between 420nm and 460nm.

7. Light-emitting diode as claimed in any one of claims 1 to 6,
**characterised in that** the semiconductor body (1) is disposed in a recess (9) of a basic housing (8) and that the recess (9) is filled at least partially by the luminescence conversion encapsulation.

8. Light-emitting diode as claimed in any one of claims 1 to 7, **characterised in that** the luminescence conversion encapsulation comprises several layers which have different wavelength conversion properties.

9. Light-emitting diode as claimed in any one of claims 1 to 8,
**characterised in that** the inorganic luminescent material originates from the group which includes the rare earth-doped garnets, rare earth-doped alkaline earth sulphides, rare earth-doped thiogallates, rare earth-doped aluminates and rare earth-doped orthosilicates.

10. Light-emitting diode as claimed in claim 9,
**characterised in that** the inorganic luminescent material originates from the group of Ce-doped garnets, in particular is YAG:Ce.

11. Light-emitting diode as claimed in any one of claims 1 to 10,
**characterised in that** the inorganic luminescent material is embedded in a matrix of thermoplastic or duroplastic material, such as epoxy resins and acrylic resins.

12. Light-emitting diode as claimed in any one of claims 1 to 10,
**characterised in that** the inorganic luminescent material is embedded in a matrix of low-melting inorganic glass.

13. Light-emitting diode as claimed in claim 9,
**characterised in that** the inorganic luminescent material is Ce-doped and applied directly to the semiconductor body (1).

14. Light-emitting diode as claimed in any one of claims 1 to 13,
**characterised in that** the inorganic luminescent material
- is YAG:Ce and is embedded in epoxy resin or a low-melting inorganic glass and
- has a median particle size of approx. 10 µm.

15. Light-emitting diode as claimed in any one of claims 1 to 14,
**characterised in that** the luminescence conversion encapsulation is provided with a plurality of different luminescent materials (6).

16. Light-emitting diode as claimed in any one of claims 1 to 15,
**characterised in that** the luminescence conversion element comprises dye molecules with and without a wavelength conversion effect.

17. Light-emitting diode as claimed in any one of claims 1 to 16,
**characterised in that** the luminescence conversion encapsulation and/or a transparent encapsulation (10, 15) is provided with a luminescent material which is luminescent in the blue range.

18. Use of a plurality of light-emitting diodes in accordance with any one of claims 1 to 17 in a full colour-capable LED display device.

19. Use of a plurality of light-emitting diodes in accordance with any one of claims 1 to 17 to provide internal lighting in aircraft cabins.

20. Use of a light-emitting diode in accordance with any one of claims 1 to 17 to illuminate display devices, in particular to illuminate liquid crystal displays.

## Revendications

1. Diode électroluminescente présentant
- un corps semi-conducteur (1), qui, pendant le fonctionnement de la diode électroluminescente, émet un rayonnement électromagnétique, comprenant au moins un premier et au moins un deuxième raccords électriques (2, 3), qui sont raccordés de manière électroconductrice au corps semi-conducteur (1), le corps semi-conducteur (1) présentant une succession de couches semi-conductrices (7), qui, pendant le fonction du composant semi-conducteur, est apte à émettre un rayonnement électromagnétique d'une première gamme de longueurs d'ondes qui comprend un rayonnement au moins du domaine spectral ultraviolet, bleu ou vert, et
- une enveloppe de conversion de luminescence (5) qui entoure au moins une partie du corps semi-conducteur (1) et convertit un rayonnement provenant de la première gamme de longueurs d'ondes en rayonnement d'une seconde gamme de longueurs d'ondes différente de la première, de manière à ce que la diode électroluminescente émette un rayonnement complexe constitué du rayonnement de la première gamme de longueurs d'ondes et du rayonnement de la seconde gamme de longueurs d'ondes,
**caractérisée en ce que** l'enveloppe de conversion de luminescence (5)
- présente une substance luminescente anorganique (6) sous forme de poudre, les particules de la substance luminescente ne se dissolvant pas dans une substance les entourant, et la substance luminescente anorganique ainsi que la substance l'entourant présentant des indices de réfraction différents les uns des autres, et
- **en ce qu'**elle présente des particules diffusant la lumière en plus de la substance luminescente anorganique.

2. Diode électroluminescente selon la revendication 1,
**caractérisée en ce que** l'élément de conversion de luminescence convertit un rayonnement de la première gamme de longueurs d'ondes en rayonnement de plusieurs secondes gammes de longueurs d'ondes provenant de domaines spectraux partiels différents les uns des autres, de manière à ce que le composant semi-conducteur émette un rayonnement complexe constitué du rayonnement de la première gamme de longueurs d'ondes et du rayonnement de la seconde gamme de longueurs d'ondes.

3. Diode électroluminescente selon l'une quelconque des revendications 1 à 2,
**caractérisée en ce que** la seconde, respectivement les secondes gammes de longueurs d'ondes présentent des longueurs d'ondes λ plus grandes que la première gamme de longueurs d'ondes.

4. Diode électroluminescente selon l'une quelconque des revendications 1 à 3,
**caractérisée en ce que** la première gamme de longueurs d'ondes et la seconde gamme de longueurs d'ondes du rayonnement complexe sont situées au moins en partie dans des domaines spectraux de couleurs complémentaires les uns par rapport aux autres, de sorte que de la lumière blanche est générée.

5. Diode électroluminescente selon la revendication 2 ou selon la revendication 2 en liaison avec l'une quelconque des revendications 3 à 4,
**caractérisée en ce que** la première gamme de longueurs d'ondes émise par le corps semi-conducteur et deux secondes gammes de longueurs d'ondes donnent une triade couleur additive, de manière à ce que pendant le fonctionnement du composant semi-conducteur de la lumière blanche soit émise par celui-ci.

6. Diode électroluminescente selon l'une quelconque des revendications 1 à 5,
**caractérisée en ce que** le rayonnement émis par le corps semi-conducteur (1), présente un maximum d'intensité de luminescence à une longueur d'onde λ ≤ 520nm, notamment dans le domaine spectral bleu à une longueur d'onde comprise entre 420 nm et 460 nm.

7. Diode électroluminescente selon l'une quelconque des revendications 1 à 6,
**caractérisée en ce que** le corps semi-conducteur (1) est disposé dans un évidement (9) d'un boîtier de base (8) et **en ce que** l'évidement (9) est rempli au moins en partie par l'enveloppe de conversion de luminescence.

8. Diode électroluminescente selon l'une quelconque des revendications 1 à 7,
**caractérisée en ce que** l'enveloppe de conversion de luminescence présente plusieurs couches ayant différentes caractéristiques de conversion de longueurs d'ondes.

9. Diode électroluminescente selon l'une quelconque des revendications 1 à 8,
**caractérisée en ce que** la substance luminescente anorganique provient du groupe comprenant les grenats dopés avec des terres rares, les sulfures alcalino-terreux dopés avec des terres rares, les thiogallates dopés avec des terres rares, les aluminates dopés avec des terres rares et les orthosilicates dopés avec des terres rares.

10. Diode électroluminescente selon la revendication 9,
**caractérisée en ce que** la substance luminescente anorganique provient du groupe des grenats dopés avec du Ce, notamment **en ce qu'**elle est du YAG:Ce.

11. Diode électroluminescente selon l'une quelconque des revendications 1 à 10,
**caractérisée en ce que** la substance luminescente anorganique est encastrée dans une matrice composée de matière thermoplastique ou thermodurcissable, telles que les résines époxydiques et les résines acryliques.

12. Diode électroluminescente selon l'une quelconque des revendications 1 à 10,
**caractérisée en ce que** la substance luminescente anorganique est encastrée dans une matrice composée de verre anorganique à bas point de fusion.

13. Diode électroluminescente selon la revendication 9, **caractérisée en ce que** la substance luminescente anorganique est dopée avec du Ce et est appliquée directement sur le corps semi-conducteur (1).

14. Diode électroluminescente selon l'une quelconque des revendications 1 à 13,
**caractérisée en ce que** la substance luminescente anorganique
- est du YAG:Ce et est encastrée dans de la résine époxydique ou dans un verre anorganique à bas point de fusion et
- présente une taille de particule médiane d'env. 10 µm.

15. Diode électroluminescente selon l'une quelconque des revendications 1 à 14,
**caractérisée en ce que** l'enveloppe de conversion de luminescence est munie de différentes substances luminescentes (6).

16. Diode électroluminescente selon l'une quelconque des revendications 1 à 15,
**caractérisée en ce que** l'élément de conversion de luminescence présente des molécules de matière colorante avec et sans effet de conversion de longueurs d'ondes.

17. Diode électroluminescente selon l'une quelconque des revendications 1 à 16,
**caractérisée en ce que** l'enveloppe de conversion de luminescence et/ou une enveloppe transparente (10, 15) est munie d'une substance luminescente dans le bleu.

18. Utilisation d'une pluralité de diodes électroluminescentes selon l'une quelconque des revendications 1 à 17 dans un dispositif d'affichage à LED apte aux tous les couleurs.

19. Utilisation d'une pluralité de diodes électroluminescentes selon l'une quelconque des revendications 1 à 17 pour l'éclairage intérieur de cabines d'avions.

20. Utilisation d'une diode électroluminescente selon l'une quelconque des revendications 1 à 17 pour l'éclairage de dispositifs d'affichage, notamment pour l'éclairage d'affichages à cristaux liquides.
